# EUROPEAN PATENT SPECIFICATION

(11) **EP 3 289 607 B1**
(45) Date of publication and mention of the grant of the patent: **24.12.2025**
(21) Application number: 16787087.2
(22) Date of filing: 27.04.2016
(51) Int. Cl.: G06V 10/40, H01L 21/66

(54) **AUTOMATED IMAGE-BASED PROCESS MONITORING AND CONTROL**
AUTOMATISIERTE BILDBASIERTE PROZESSÜBERWACHUNG UND STEUERUNG
SURVEILLANCE ET COMMANDE DE PROCESSUS AUTOMATISÉES À BASE D'IMAGES

(30) Priority: 30.04.2015 US 201562155200 P; 22.06.2015 US 201514746820
(43) Date of publication of application: 07.03.2018
(73) Proprietor: KLA - Tencor Corporation, Milpitas, California 95035 (US)
(72) Inventor: VAJARIA, Himanshu, San Jose, California 95134 (US); GHADAR, Shabnam, Sunnyvale, CA 94086 Santa Clara (US); TORELLI, Tommaso, San Mateo, California 94403 (US); RIES, Bradley, San Jose, California 95120 (US); MAHADEVAN, Mohan, Livermore, CA 94550 (US); PANDEV, Stilian, Santa Clara, California 95050 (US)
(74) Representative: FRKelly
(86) International application number: PCT/US2016/029608
(87) International publication number: WO 2016/176354

(56) References cited:
- WO-A1-2009/018337
- US-A1- 2009 290 782
- US-A1- 2010 235 134
- US-A1- 2012 057 773
- US-A1- 2013 163 851
- US-A1- 2013 188 859
- US-A1- 2013 336 575

## Description

### Field of the Disclosure

The disclosure relates to monitoring and control of wafer manufacturing processes.

### Background of the Disclosure

Semiconductor devices such as logic and memory devices are typically fabricated by a sequence of processing steps applied to a substrate or wafer. The various features and multiple structural levels of the semiconductor devices are formed by these processing steps. For example, lithography is a semiconductor fabrication process that involves generating a pattern on a semiconductor wafer. Additional examples of semiconductor fabrication processes include, but are not limited to, chemical-mechanical polishing (CMP), etch, deposition, and ion implantation. Multiple semiconductor devices may be fabricated on a single semiconductor wafer and then separated into individual semiconductor devices.

Inspection processes are used at various steps during a semiconductor manufacturing process to detect defects on wafers to promote higher yield. As design rules and process windows continue to shrink in size, inspection systems are required to capture a wider range of physical defects on wafer surfaces while maintaining high throughput.

Wafer manufacturing process control is typically performed based on low wafer sampling using a slow, but sensitive, inspection tool, followed by review using a scanning electron microscope (SEM). In some cases, process monitoring and control is achieved by way of a learning-based method where a process engineer learns how long the process tool can be used before requiring maintenance. This process engineer-based approach is prone to random failures since there is no in-line feedback. In both of these previous techniques, issues are only detected once a process tool has become problematic and creates defects that can be observed on inspection. Additionally, these techniques are slow, and therefore, wafer sampling is low.

Previous high-throughput approaches lack sensitivity and versatility. For example, previous techniques may detect known patterns in pre-defined zones on a wafer.

WO2009/018337 discloses various methods, carrier media, and systems for monitoring a characteristic of a specimen.

US2013/336575 describes an analysis system for detection of defects within an inspection image of an inspected object.

Accordingly, there is a need for high-throughput process monitoring and control that is capable of detecting non-compliance based on previously unknown patterns.

### Brief Summary of the Disclosure

The present disclosure provides a method for generating a model for detecting process non-compliance as recited in claim 1. The present disclosure further provides a device for detecting process non-compliance as recited in claim 5, and a method for detecting process non compliance using the model of claim 1 as recited in claim 4.

The scope of the invention is defined by the appended set of claims.

### Description of the Drawings

For a fuller understanding of the nature and objects of the disclosure, reference should be made to the following detailed description taken in conjunction with the accompanying drawings, in which:
Figure 1 is a diagrammatic view of a method according to the present disclosure;
Figure 2 is a macro debug image of a wafer, wherein the wafer includes a set of dies;
Figure 3 depicts a median die and portions of surrounding dies;
Figure 4 is an intensity histogram of a median die;
Figure 5 illustrates five intensity-based segment masks;
Figure 6 illustrates five standard deviation-based segment masks;
Figure 7 illustrates five principal component-based segment masks;
Figure 8 illustrates an array of resulting wafer images generated for each combination of segment mask (in the rows) and metrics (in the columns);
Figure 9 is a chart showing an exemplary set of metrics calculated for masked die images;
Figure 10 is a chart showing a method according to an embodiment of the present disclosure;
Figure 11 is a chart showing a method according to another embodiment of the present disclosure; and
Figure 12 is a diagram of a device according to an embodiment of the present disclosure.

### Detailed Description of the Disclosure

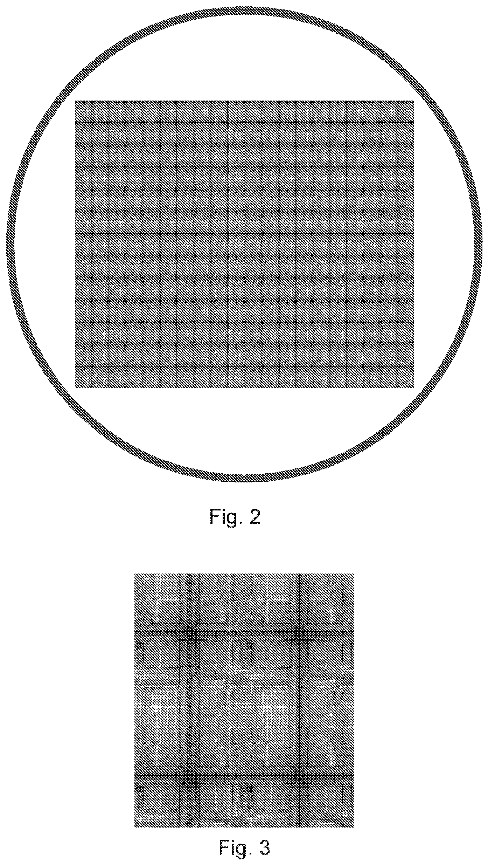

The present disclosure may be embodied as a method **100** for generating a model for detecting process non-compliance. The method **100** comprises receiving **103** a plurality of wafer images (*see, e.g.,* Figure 2). The received **103** wafer images may be images of the same wafer, where each image is captured using a different modality such as, for example, bright field illumination, dark field illumination, polarized light, red light, blue light, green light, white light, etc., or combinations In other embodiments, the received **103** wafer images may be images of different wafers. In other embodiments, the wafer images comprise both images of the same wafer and images of different wafers. Each received **103** wafer image includes a set of images of the dies (*see, e.g.,* Figure 3).

For each received **103** wafer image, the inspection results of each die are received **106.** As such, for a wafer, a wafer image is received **103**, and a set of inspection results is received **106,** where each inspection result of the set corresponds to a die of the set of dies for the wafer. The received **106** inspection results may be a simple pass/fail indication for each die. In other embodiments, the received **106** inspection results may indicate pass or fail, and further indicate one or more reasons for the failure. For example, for a lithography module (a production tool used for lithography), a die may fail due to alignment, fidelity, focus, reticle tilt, critical dimension, overlay, particles, etc. In a CMP module, failure may be due to polishing defects, contamination, scratches, etc. In a deposition module, failure may be due to alignment, contamination, film thickness, etc. Other failure types are known and can be incorporated. As such, the method **100** may be used to generate a classification model having multiple classes (*e.g.*, pass, alignment failure, or scratched-a three-class model). In general, this model can also be of the regression type where a discrete model can be replaced with a continuous model.

While the method **100** may be used to detect problems once they have occurred, the model may also be used to detect impending signs of problems before they occur. The method **100** is not specific to any single class of process problems. Embodiments of the present technique have a universality such that the technique can be applied across any or all process modules in a fab.

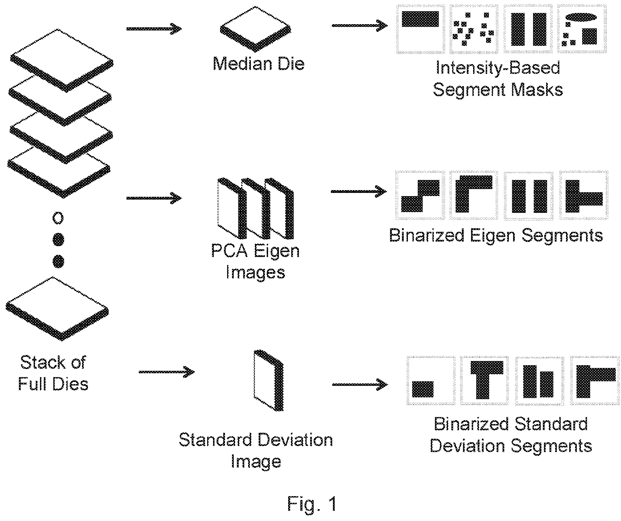

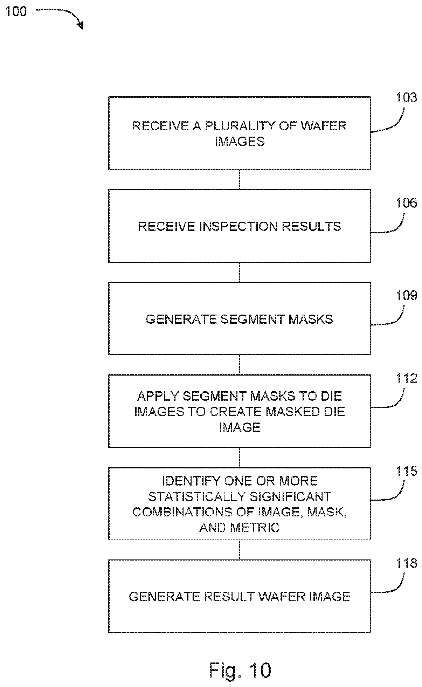

The method **100** comprises generating **109** segment masks based on the die images of each set of die images (*see*, *e.g.,* Figures 1 and 10). Segment masks allow each image (wafer and/or die) to be masked to show only the portion of the image having potentially useful information (*i.e.*, signal) while masking information that is potentially less useful (*i.e.*, noise). It should be noted that different structures in the die are capable of carrying different levels of process information. Significant amounts of process information are hidden in the data as these structures are inspected with the combinations of optical parameters. This rich process information can be extracted by applying the types of analysis disclosed herein. An aspect of this analysis is the segmentation of the different kinds of structures in the die into various groups. The signal is accumulated within each group to further enhance the signal to noise ratio. Each generated 109 segment mask is based on a segmentation type, where the segmentation types. Each segmentation type provides the potential of enhancing the signal-to-noise ratio.

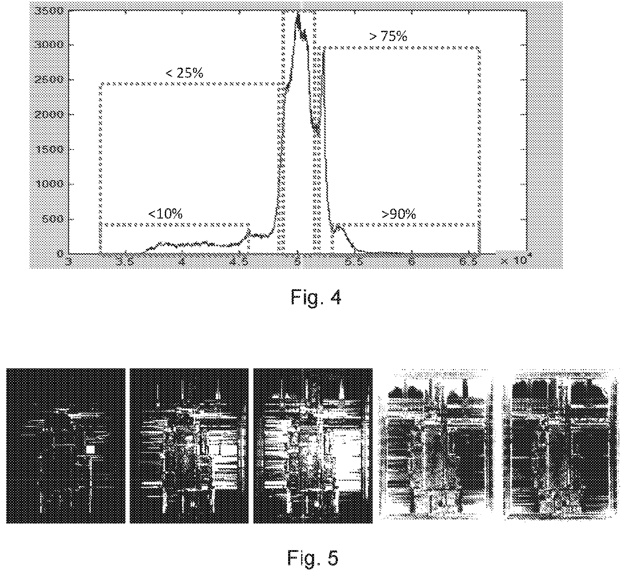

An exemplary segmentation type is an intensity-based mask. An intensity-based mask may be determined by first identifying a die having a mean intensity-the "mean die" (Figure 3). Next, an intensity histogram of the mean die is determined and used to derive at least one threshold intensity value (Figure 4). There are a variety of intensity segmentation schemes. An exemplary fixed segmentation scheme could be as shown below. Other dynamic schemes can adapt naturally to the density and response of the structures. In an example of a fixed scheme, the threshold value may be set to mask the 25% of pixels with the lowest intensities, or the 25% of pixels with the greatest intensities. In an exemplary embodiment illustrated in Figure 5, five intensity-based segment masks are generated **109** by setting threshold values at <10% (the ten percent of pixels with the lowest intensities), < 25%, 50%, >75%, and >90% (the ten percent of pixels with the highest intensities). In another embodiment, the threshold values are set based on 10%, 30%, 50%, 70%, and 90% intensities. It should be noted that other intensity values may be used as thresholds and that masks may be set to be greater than or less than a threshold, according to the desired result. (Note that Figures 2-6 and 7-8 are images generated solely to illustrate embodiments of the present disclosure and are not actual data).

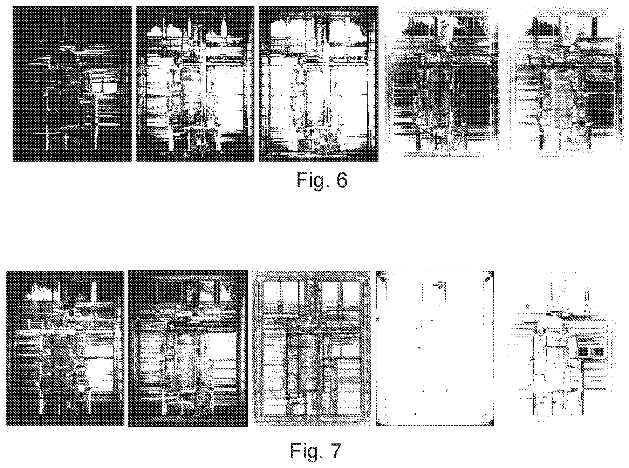

In another segmentation type illustrated in Figure 6, threshold values are selected based on standard deviation. For example, a threshold value may be set at one standard deviation (1σ) below a selected value, such as a histogram peak value of the mean die. In a particular example, masks are generated **109** at threshold values set to ± 2σ and ± 1σ-resulting in four segment masks.

In another segmentation type illustrated in Figure 7, mask threshold values are selected based on a principal component analysis (PCA). A median die image is selected, and the image values are subtracted from each other die image of the set of die images. In this way, a "difference die" image is created for each die. A PCA of these difference dies provides masks, where each mask corresponds with each principal component (eigenvector) resulting from the PCA providing a threshold value for a different mask. The number of eigenvectors (and therefore the number of resulting masks) can be selected according to the particular application, as is known in the art. In an exemplary embodiment, the first five principal components are selected. In this way, the masks capture regions with high variance across dies.

While some of the above examples use a mean die image, for example, to create a difference die image or to threshold a histogram, it should be noted that embodiments may alternatively or additionally use a reference die image.

As stated above, each segmentation type may be selected in an attempt to enhance the signal-to-noise ratio. For example, it may be determined that in a particular process and with a particular wafer configuration (perhaps having large structures), an intensity-based mask provides a beneficial improvement in signal-to-noise ratio, while the intensity-based mask may not be useful for the same process acting on a different patterned wafer (perhaps having fine structures). Other segmentation types can be used to create masks and will be apparent in light of the present disclosure. For example, other automatic thresholding techniques may be more appropriately used to generate **109** a segment mask where a histogram results in a bimodal distribution.

Each generated **109** segment mask is then applied **112** to each die image such that a masked die image is created. A set of metrics is calculated for each masked die image (*i.e.,* for each masked region). Any one or more metrics may be selected as appropriate to an application. Metrics may be provided for one or more of intensity, x,y symmetry, radial symmetry, angular symmetry, frequency, or otherwise. And multiple metrics may be calculated for each of these categories. For example, for a metric may be calculated as the mean of the thresholded masked die image (0-50%). And another mean may be calculated of the thresholded masked die image (50-100%). Another metric may be a standard deviation of the thresholded masked die image from 0-50% and another thresholded 50-100%.

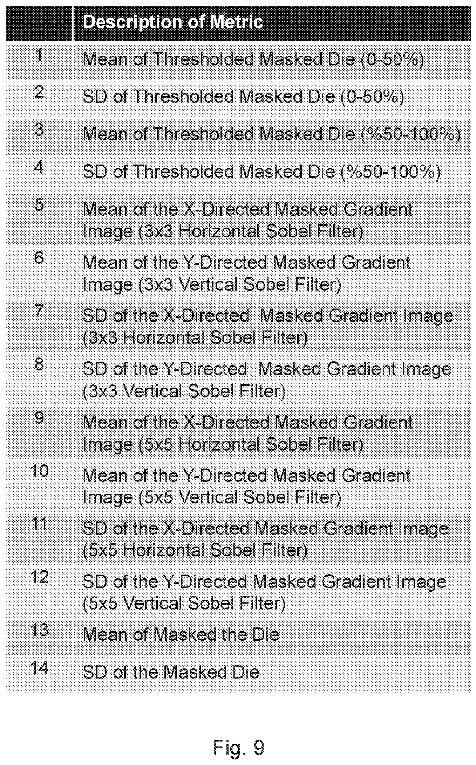

Other examples of metrics include (see also Figure 9):
- Mean of the x-directed masked gradient image using a 3x3 horizontal Sobel filter.
- Mean of the y-directed masked gradient image using a 3x3 horizontal Sobel filter.
- Standard deviation of the x-directed masked gradient image using a 3x3 horizontal Sobel filter.
- Standard deviation of the y-directed masked gradient image using a 3x3 horizontal Sobel filter.
- Mean of the x-directed masked gradient image using a 5x5 horizontal Sobel filter.
- Mean of the y-directed masked gradient image using a 5x5 horizontal Sobel filter.
- Standard deviation of the x-directed masked gradient image using a 5x5 horizontal Sobel filter.
- Standard deviation of the y-directed masked gradient image using a 5x5 horizontal Sobel filter.

It should be noted that the above list of metrics is not exhaustive and other metrics are known and can be used. In other embodiments, the segment masks are manually generated **109** by an operator. For example, an operator may manually delineate structures by drawing the segments as desired. This may be beneficial in cases where, for example, there is *a priori* information regarding certain structures on the die. In some embodiments, the segmentation can be drawn from a rendered CAD model where specific structures are grouped into segments.

A detection model results by identifying **115** one or more statistically significant combinations of metric, segment mask, and wafer image based on the die inspection results. Statistical processes can be used to determine the significant processes. For example, linear regression may be used to determine the relationship between the die inspection results and a combination of metric, segment mask, and wafer image.

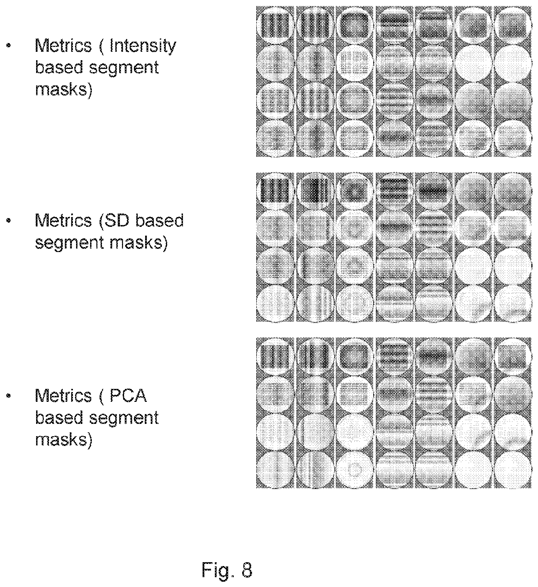

The method **100** may comprise generating **118** a result wafer image for each combination of wafer image, segment mask, and metric. Each generated **118** result wafer image comprises a set of result die images based on the corresponding combination. For example, Figure 8 depicts wherein a particular wafer image has been segmented in twelve ways-four intensity-based segment masks, four SD-based segment masks, and four PCA-based segment masks. The number of segmented images may be more or less, as discussed above. In turn, fourteen metrics are calculated for each masked wafer image as shown in Figure 9. Result wafer images are generated **118** for each combination. It can be seen in Figure 8 that certain result wafer images may depict variations in the wafer that are different than the variations (or lack thereof) depicted other result images. For example, the result image at row 1, column 5 (corresponding to an intensity-based segment mask combined with a mean of the x-directed masked gradient image (using a 3x3 horizontal Sobel filter)) depicts variations which have a pattern different from the result image in row 10, column 11 (corresponding to a second principal component segment mask combined with a SD of the x-directed masked gradient image (using a 5x5 horizontal Sobel filter)). Such result images depict graphically how combinations may correlate with wafer artifacts, and therefore, potentially useful information process information.

Steps of the method **100** may be repeated for additional wafer images in order to refine the model. For example, the steps may be repeated for additional wafer images having different image modalities (than the image modalities previously used in the method). In this way, the resulting model can be improved where additional statistically significant combinations are found. In another example, the steps may be repeated for additional wafer images with the same modalities of previously-used images-for example, the additional images are images of additional wafers that were not previously used in the method. As such, the resulting model can be improved through the use of additional data points. In this way, a device using the method **100** in a manufacturing environment can continuously improve its detection model.

The method **100** provides techniques for extracting wafer-scale process information that is otherwise lost in a die-to-die analysis. Using the disclosed techniques, information can be extracted from bright-field and dark-field images, and information may be extracted with the pattern (raw image) and/or with the pattern removed (difference image). By integrating information over a segment, the signal-to-noise ratio of the information is enhanced. This enables the detection of weak trends, as such, process module maintenance may be predictive rather than reactive. Predictive module maintenance can save unnecessary maintenance cycles, while also reducing material risk by flagging the need for process tool preventative maintenance prior to a next scheduled maintenance.

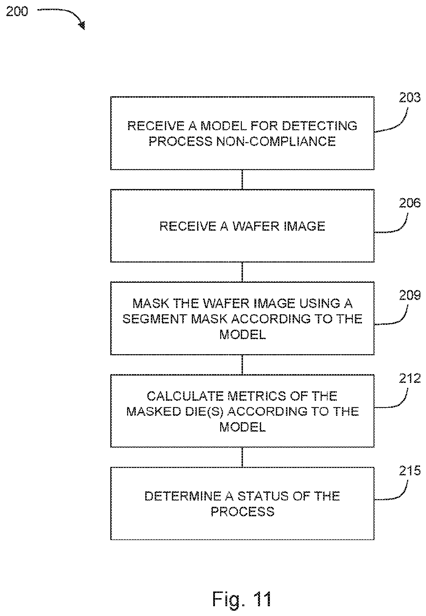

In another embodiment, such as that depicted in Figure 11, a method **200** is provided for detecting process non-compliance. The method **200** includes the step of receiving **203** a pre-determined model capable of detecting a process non-compliance. The received **203** model may be, for example, a model generated using the method **100** described above. The received **203** model is based on statistically significant combination(s) of metrics of segment masks, metrics, and wafer images. The ability of the presently disclosed technique to examine this holistically makes it very powerful. Here holistically refers to looking at optical modalities, die structures and algorithmic calculations together. In an embodiment used solely to illustrate the method, a model is received for detecting a process non-compliance, and the model indicates the significant (for the modality of the wafer image) combinations of: (1) a -1σ segment mask and a mean of the thresholded masked die image (0-50%); and (2) a first principal component segment mask and a mean of the y-directed masked gradient image using a 5x5 horizontal Sobel filter.

A wafer image is received **206.** The wafer image comprises a set of die images. For example, the wafer image may be received **206** by a computer at a network port. In other cases, a processor receives **206** a wafer image by retrieving the image from storage. In another example, a processor receives **206** a wafer image from a connected camera or other imaging sensor. The wafer image is taken using a imaging modality such as dark-field illumination, bright-field illumination, colored-light illumination (red, blue, green, white, etc.) or other modalities and combinations thereof.

The wafer image is masked **209** using a segment mask of the model. In the illustrative example, the wafer image is masked **209** using a -1σ segment mask and a first principal component segment mask. Metrics of the masked **209** dies are then calculated **212.** For the illustrative example, the mean of the thresholded masked die image (0-50%) is calculated for the die image masked **209** with the SD mask, and a mean of the y-directed masked gradient image is calculated **212** for die image masked **209** with the PCA mask. The masking step **209** and the metrics calculation step **212** are repeated for each combination in the model.

The process status (*i.e.,* compliant or non-compliant) is determined **215** based on the calculated **212** metric(s) and the model. Continuing with the illustrative example, the received **203** model may indicate that a process is compliant when the first significant combination (SD-based mask and intensity-based metric) shows a variance across the wafer image of less than a modelled value (*N*) and the second significant combination (PCA-based mask and gradient-based metric) shows a variance across the wafer of less than a modelled value (*M*). In some cases, the values of *N* and *M* are independent of one another, while in other cases, there may be a relationship where value of *N* varies according to the value of*M*.

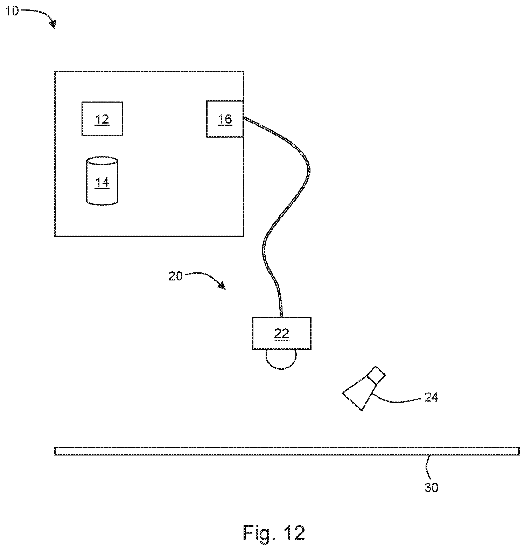

The present disclosure may be embodied as a device **10** for detecting non-compliance of a process (*see, e.g.,* Figure 12). The device **10** comprises a processor **12** and a storage device **14** in electronic communication with the processor **12**. The device **10** further comprises a communication port **16** in electronic communication with the processor **12**. For example, the communication port **16** may be a network port, such as an Ethernet port or a wireless Ethernet port.

In other embodiments, the device **10** may include an imaging device **20**, and the communication port **16** may be, for example, a serial interface to the imaging device **20**. The imaging device **20** comprises an imaging sensor **22**. The imaging sensor **22** may be, for example, a charge-coupled device (CCD) or a time delay and integration (TDI) sensor. The imaging device **20** may further comprise an illumination source **24**. The illumination source **24** may be configured as a bright-field source or a dark-field source, as is known in the art. The illumination source **24** may be a broad-spectrum source, such as a white light source, or a more narrow-spectrum source, such as a red light, blue light, or green light source. The imaging device **20** may be configured to capture images using polarized light. The imaging device **20** may comprise more than one illumination sources **24** such that the device **10** may take advantage of images having different modalities. Other imaging modalities and imaging device **20** configurations are known and will be apparent in light of the present disclosure. The imaging device **20** is configured to capture an image of a wafer. For example, the wafer image may be captured while a wafer is being transported through the device **10**.

The processor **12** is programmed to perform any of the methods described above. In an example, the processor **12** is programmed to receive a plurality of wafer images of a wafer at the communication port **16**. Each wafer image of the plurality of wafer images comprises a set of die images (the dies of the wafer). The processor **12** is further programmed to receive, at the communication port **16,** an inspection result of each die of to the sets of die images As such, for each wafer image of the plurality of wafer images, the processor **12** receives a die inspection result for each die of the wafer.

The processor **12** is programmed to generate a set of segment masks, the segment masks based on the die images of each set of die images and one or more segmentation types. The processor **12** is programmed to apply the segment masks to each die image to create a masked die image. A set of metrics is calculated for each masked die image. The processor **12** is programmed to identify one or more statistically significant combinations of metric, segment mask, and wafer image (*i.e.*, modality) based the die inspection results. In this way, the processor **12** will generate a model for detecting a process non-compliance based on the identified combinations.

This model can be used as a feedback mechanism to adjust a processing tool, such as a CMP tool or to provide a notification that the processing tool requires maintenance. As such, the processor **12** may send instructions to a processing tool by way of the communication port **16**. Additionally or alternatively, the processor **12** may send a maintenance notification signal by way of the communication port **16** or otherwise (*e.g.,* an alarm device, etc.) In some embodiments, the device **10** may comprise a transport stage **30** capable of routing wafers for rework or scrap. In such embodiments, the processor **12** may be programmed to route a wafer for rework or scrap.

Although the present disclosure has been described with respect to one or more particular embodiments, it will be understood that other embodiments of the present disclosure may be made. Hence, the present disclosure is deemed limited only by the appended claims.

## Claims

1. A method for generating a model for detecting process non-compliance, comprising:
receiving a plurality of wafer images, each wafer image of the plurality of wafer images comprising a set of die images;
receiving an inspection result of each die corresponding to the set of die images, wherein the inspection result comprises a pass or fail indication for each die;
generating segment masks based on the die images of each set of die images and one or more segmentation types, wherein each segment mask is configured to mask portions of the die images containing particular die structures such that only a portion of each of the die images is shown, wherein the one or more segmentation types includes determining a mean die based on intensity of the die images and thresholding an image of the mean die based on values of the intensity histogram of the median die, wherein the values are less than 10%, less than 25%, less than 50%, more than 75%, and more than 90% intensity, wherein the one or more segmentation types includes subtracting the median die from each of the die images to generate a set of difference dies, and calculating one or more principal components of the set of difference dies;
applying, using a processor, each segment mask to each die image to create a masked die image, and calculating a set of metrics for each masked die image, wherein the set of metrics includes one or more of: a mean of an image, a standard deviation of an image, a mean of a thresholded masked image, a standard deviation of a thresholded masked image, mean of an x-directed masked gradient image, mean of a y-directed masked gradient image, standard deviation of an x-directed masked gradient image, and standard deviation of a y-directed masked gradient image;
identifying, using the processor, one or more statistically significant combinations of metric, segment mask, and wafer image, based on the die inspection results to generate a detection model for indicating process compliance or non-compliance, wherein said detection model uses linear regression to determine a relationship such that the die inspection results, indicating a binary response of process compliance or non-compliance, is predicted by a combination of said metrics calculated from the masked die images, segment mask and wafer image, and wherein the statistically significant combinations are determined based on the particular process or wafer configuration; and
generating, using the processor, a result wafer image for each combination of wafer image, segment mask, and metric, said result wafer image comprising a set of result die images, each result die image visually representing the calculated metric value for a corresponding die on the wafer, thereby visually indicating variations across the wafer that correlate with process compliance or non-compliance.

2. The method of claim 1, wherein the plurality of wafer images comprises one or more of a blue light image, a red light image, a white light image, a green light image, a dark field image, a bright field image, and a polarized image.

3. The method of claim 1, wherein the steps of receiving wafer images, receiving inspection results, generating segment masks, and applying segment masks are repeated for additional wafer images comprising images of additional wafers not previously used, and further comprising the step of identifying, using the processor, one or more additional statistically significant combinations of metric, segment mask, and wafer image, based on the die inspection results, to refine said detection model by updating the relationship determined by linear regression to incorporate said additional statistically significant combinations, thereby improving the detection model's accuracy in indicating process compliance or non-compliance.

4. A method for detecting non-compliance of a process, comprising:
receiving a model generated in accordance with the method as claimed in claim 1;
receiving a wafer image comprising a set of die images;
masking the wafer image using a segment mask of the model;
calculating a metric of the masked image based on a corresponding combination of segment mask and metric from the model;
repeating the steps of masking the wafer image and calculating a metric based on each combination of segment mask and metric from the model; and
determining a process status based on the calculated metrics and the model to detect a compliance or non-compliance status of the process.

5. A device for generating a model for detecting process non-compliance, comprising:
a processor;
a storage device in electronic communication with the processor;
a communication port in electronic communication with the processor;
wherein the processor is programmed to:
receive, at the communication port, a plurality of wafer images of a wafer, each wafer image of the plurality of wafer images comprising a set of die images;
receive, at the communication port, an inspection result of each die corresponding to the set of die images, wherein the inspection result comprises a pass or fail indication for each die;
generate a set of segment masks, the segment masks based on the die images of each set of die images and one or more segmentation types, wherein each segment mask is configured to mask portions of the die images containing particular die structures such that only a portion of each of the die images is shown, wherein the one or more segmentation types includes determining a mean die based on intensity of the die images and thresholding an image of the mean die based on values of the intensity histogram of the median die, wherein the values are less than 10%, less than 25%, less than 50%, more than 75%, and more than 90% intensity, wherein the one or more segmentation types includes subtracting the median die from each of the die images to generate a set of difference dies, and calculating one or more principal components of the set of difference dies;
apply each segment mask to each die image to create a masked die image, and calculating a set of metrics for each masked die image, wherein the set of metrics includes one or more of: a mean of an image, a standard deviation of an image, a mean of a thresholded masked image, a standard deviation of a thresholded masked image, mean of an x-directed masked gradient image, mean of a y-directed masked gradient image, standard deviation of an x-directed masked gradient image, and standard deviation of a y-directed masked gradient image;
generate a result wafer image for each combination of wafer image, segment mask, and metric, said result wafer image comprising a set of result die images, each result die image visually representing the calculated metric value for a corresponding die on the wafer, thereby visually indicating variations across the wafer that correlate with process compliance or non-compliance; and
identify statistically significant combinations based on the result wafer images and the die inspection results to generate a detection model for indicating process compliance or non-compliance wherein said detection model uses linear regression to determine a relationship such that the die inspection results, indicating a binary response of process compliance or non-compliance, is predicted by a combination of said metrics calculated from the masked die images, segment mask and wafer image, and wherein the statistically significant combinations are determined based on the particular process or wafer configuration.

6. The device of claim 5, wherein the processor is further programmed to:
repeat each program step for additional wafers; and
refine the generated detection model according to the statistically significant combinations for each wafer by updating the relationship determined by linear regression to incorporate additional statistically significant combinations, thereby improving the detection model's accuracy in indicating process compliance or non-compliance.

7. The device of claim 5, wherein the plurality of wafer images of a wafer comprises one or more of a blue light image, a red light image, a white light image, a green light image, a dark field image, a bright field image, and a polarized image.

## Patentansprüche

1. Verfahren zum Erzeugen eines Modells zum Erkennen von Prozessnichtkonformität, umfassend:
Empfangen einer Vielzahl von Waferbildern, wobei jedes Waferbild der Vielzahl von Waferbildern einen Satz von Die-Bildern umfasst;
Empfangen eines Inspektionsergebnisses jedes Die, das dem Satz von Die-Bildern entspricht, wobei das Inspektionsergebnis eine Gut- oder Schlecht-Anzeige für jedes Die umfasst;
Erzeugen von Segmentmasken basierend auf den Die-Bildern jedes Satzes von Die-Bildern und einem oder mehreren Segmentierungstypen, wobei jede Segmentmaske so konfiguriert ist, dass sie Teile der Die-Bilder maskiert, die bestimmte Die-Strukturen enthalten, sodass nur ein Teil jedes der Die-Bilder gezeigt wird, wobei der eine oder die mehreren Segmentierungstypen das Bestimmen eines mittleren Die basierend auf der Intensität der Die-Bilder und das Schwellenwerten eines Bildes des mittleren Die basierend auf Werten des Intensitätshistogramms des Median-Die umfassen, wobei die Werte weniger als 10 %, weniger als 25 %, weniger als 50 %, mehr als 75 % und mehr als 90 % Intensität betragen, wobei der eine oder die mehreren Segmentierungstypen das Subtrahieren des Median-Die von jedem der Die-Bilder, um einen Satz von Differenz-Dies zu erzeugen, und das Berechnen einer oder mehrerer Hauptkomponenten des Satzes von Differenz-Dies umfassen;
Anwenden, unter Verwendung eines Prozessors, jeder Segmentmaske auf jedes Die-Bild, um ein maskiertes Die-Bild zu erstellen, und Berechnen eines Satzes von Metriken für jedes maskierte Die-Bild, wobei der Satz von Metriken eines oder mehrere umfasst von: einem Mittelwert eines Bildes, einer Standardabweichung eines Bildes, einem Mittelwert eines schwellenwertgefilterten maskierten Bildes, einer Standardabweichung eines schwellenwertgefilterten maskierten Bildes, einem Mittelwert eines in x-Richtung maskierten Gradientenbildes, einem Mittelwert eines in y-Richtung maskierten Gradientenbildes, einer Standardabweichung eines in x-Richtung maskierten Gradientenbildes und einer Standardabweichung eines in y-Richtung maskierten Gradientenbildes;
Identifizieren, unter Verwendung des Prozessors, einer oder mehrerer statistisch signifikanter Kombinationen aus Metrik, Segmentmaske und Waferbild, basierend auf den Die-Inspektionsergebnissen, um ein Erkennungsmodell zum Anzeigen von Prozesskonformität oder -nichtkonformität zu erzeugen, wobei das Erkennungsmodell lineare Regression verwendet, um eine Beziehung zu bestimmen, sodass die Die-Inspektionsergebnisse, die eine binäre Antwort der Prozesskonformität oder -nichtkonformität anzeigen, durch eine Kombination der aus den maskierten Die-Bildern, der Segmentmaske und dem Waferbild berechneten Metriken vorhergesagt wird, und wobei die statistisch signifikanten Kombinationen basierend auf dem jeweiligen Prozess oder der Waferkonfiguration bestimmt werden; und
Erzeugen, unter Verwendung des Prozessors, eines Ergebnis-Waferbildes für jede Kombination aus Waferbild, Segmentmaske und Metrik, wobei das Ergebnis-Waferbild einen Satz von Ergebnis-Die-Bildern umfasst, wobei jedes Ergebnis-Die-Bild den berechneten Metrikwert für ein entsprechendes Die auf dem Wafer visuell darstellt, wodurch Variationen über den Wafer, die mit Prozesskonformität oder -nichtkonformität korrelieren, visuell angezeigt werden.

2. Verfahren nach Anspruch 1, wobei die Vielzahl von Waferbildern eines oder mehrere von einem Blaulichtbild, einem Rotlichtbild, einem Weißlichtbild, einem Grünlichtbild, einem Dunkelfeldbild, einem Hellfeldbild und einem polarisierten Bild umfasst.

3. Verfahren nach Anspruch 1, wobei die Schritte des Empfangens von Waferbildern, des Empfangens von Inspektionsergebnissen, des Erzeugens von Segmentmasken und des Anwendens von Segmentmasken für zusätzliche Waferbilder wiederholt werden, die Bilder von zusätzlichen, nicht zuvor verwendeten Wafern umfassen, und ferner umfassend den Schritt des Identifizierens, unter Verwendung des Prozessors, einer oder mehrerer zusätzlicher statistisch signifikanter Kombinationen aus Metrik, Segmentmaske und Waferbild, basierend auf den Die-Inspektionsergebnissen, um das Erkennungsmodell durch Aktualisieren der durch lineare Regression bestimmten Beziehung zu verfeinern, um die zusätzlichen statistisch signifikanten Kombinationen einzubeziehen, wodurch die Genauigkeit des Erkennungsmodells beim Anzeigen von Prozesskonformität oder - nichtkonformität verbessert wird.

4. Verfahren zum Erkennen von Nichtkonformität eines Prozesses, umfassend:
Empfangen eines Modells, das gemäß dem Verfahren nach Anspruch 1 erzeugt wurde;
Empfangen eines Waferbildes, das einen Satz von Die-Bildern umfasst;
Maskieren des Waferbildes unter Verwendung einer Segmentmaske des Modells;
Berechnen einer Metrik des maskierten Bildes basierend auf einer entsprechenden Kombination aus Segmentmaske und Metrik aus dem Modell;
Wiederholen der Schritte des Maskierens des Waferbildes und des Berechnens einer Metrik basierend auf jeder Kombination aus Segmentmaske und Metrik aus dem Modell; und
Bestimmen eines Prozessstatus basierend auf den berechneten Metriken und dem Modell, um einen Konformitäts- oder Nichtkonformitätsstatus des Prozesses zu erkennen.

5. Vorrichtung zum Erzeugen eines Modells zum Erkennen von Prozessnichtkonformität, umfassend:
einen Prozessor;
eine Speichervorrichtung in elektronischer Kommunikation mit dem Prozessor;
einen Kommunikationsanschluss in elektronischer Kommunikation mit dem Prozessor;
wobei der Prozessor programmiert ist zum:
Empfangen, an dem Kommunikationsanschluss, einer Vielzahl von Waferbildern eines Wafers, wobei jedes Waferbild der Vielzahl von Waferbildern einen Satz von Die-Bildern umfasst;
Empfangen, an dem Kommunikationsanschluss, eines Inspektionsergebnisses jedes Die, das dem Satz von Die-Bildern entspricht, wobei das Inspektionsergebnis eine Gut- oder Schlecht-Anzeige für jedes Die umfasst;
Erzeugen eines Satzes von Segmentmasken, wobei die Segmentmasken auf den Die-Bildern jedes Satzes von Die-Bildern und einem oder mehreren Segmentierungstypen basieren, wobei jede Segmentmaske so konfiguriert ist, dass sie Teile der Die-Bilder maskiert, die bestimmte Die-Strukturen enthalten, sodass nur ein Teil jedes der Die-Bilder gezeigt wird, wobei der eine oder die mehreren Segmentierungstypen das Bestimmen eines mittleren Die basierend auf der Intensität der Die-Bilder und das Schwellenwerten eines Bildes des mittleren Die basierend auf Werten des Intensitätshistogramms des Median-Die umfassen, wobei die Werte weniger als 10 %, weniger als 25 %, weniger als 50 %, mehr als 75 % und mehr als 90 % Intensität betragen, wobei der eine oder die mehreren Segmentierungstypen das Subtrahieren des Median-Die von jedem der Die-Bilder, um einen Satz von Differenz-Dies zu erzeugen, und das Berechnen einer oder mehrerer Hauptkomponenten des Satzes von Differenz-Dies umfassen;
Anwenden jeder Segmentmaske auf jedes Die-Bild, um ein maskiertes Die-Bild zu erstellen, und Berechnen eines Satzes von Metriken für jedes maskierte Die-Bild, wobei der Satz von Metriken eines oder mehrere umfasst von: einem Mittelwert eines Bildes, einer Standardabweichung eines Bildes, einem Mittelwert eines schwellenwertgefilterten maskierten Bildes, einer Standardabweichung eines schwellenwertgefilterten maskierten Bildes, einem Mittelwert eines in x-Richtung maskierten Gradientenbildes, einem Mittelwert eines in y-Richtung maskierten Gradientenbildes, einer Standardabweichung eines in x-Richtung maskierten Gradientenbildes und einer Standardabweichung eines in y-Richtung maskierten Gradientenbildes;
Erzeugen eines Ergebnis-Waferbildes für jede Kombination aus Waferbild, Segmentmaske und Metrik, wobei das Ergebnis-Waferbild einen Satz von Ergebnis-Die-Bildern umfasst, wobei jedes Ergebnis-Die-Bild den berechneten Metrikwert für ein entsprechendes Die auf dem Wafer visuell darstellt, wodurch Variationen über den Wafer, die mit Prozesskonformität oder - nichtkonformität korrelieren, visuell angezeigt werden; und
Identifizieren von statistisch signifikanten Kombinationen basierend auf den Ergebnis-Waferbildern und den Die-Inspektionsergebnissen, um ein Erkennungsmodell zum Anzeigen von Prozesskonformität oder -nichtkonformität zu erzeugen, wobei das Erkennungsmodell lineare Regression verwendet, um eine Beziehung zu bestimmen, sodass die Die-Inspektionsergebnisse, die eine binäre Antwort der Prozesskonformität oder -nichtkonformität anzeigen, durch eine Kombination der aus den maskierten Die-Bildern, der Segmentmaske und dem Waferbild berechneten Metriken vorhergesagt wird, und wobei die statistisch signifikanten Kombinationen basierend auf dem jeweiligen Prozess oder der Waferkonfiguration bestimmt werden.

6. Vorrichtung nach Anspruch 5, wobei der Prozessor ferner programmiert ist zum:
Wiederholen jedes Programmschritts für zusätzliche Wafer; und
Verfeinern des erzeugten Erkennungsmodells gemäß den statistisch signifikanten Kombinationen für jeden Wafer durch Aktualisieren der durch lineare Regression bestimmten Beziehung, um zusätzliche statistisch signifikante Kombinationen einzubeziehen, wodurch die Genauigkeit des Erkennungsmodells beim Anzeigen von Prozesskonformität oder -nichtkonformität verbessert wird.

7. Vorrichtung nach Anspruch 5, wobei die Vielzahl von Waferbildern eines Wafers eines oder mehrere von einem Blaulichtbild, einem Rotlichtbild, einem Weißlichtbild, einem Grünlichtbild, einem Dunkelfeldbild, einem Hellfeldbild und einem polarisierten Bild umfasst.

## Revendications

1. Procédé de génération d'un modèle de détection de non-conformité de processus, comprenant :
la réception d'une pluralité d'images de plaquette, chaque image de plaquette de la pluralité d'images de plaquette comprenant un ensemble d'images de puce ;
la réception d'un résultat d'inspection de chaque puce correspondant à l'ensemble d'images de puce, dans lequel le résultat d'inspection comprend une indication de réussite ou d'échec pour chaque puce ;
la génération de masques de segment basés sur les images de puce de chaque ensemble d'images de puce et un ou plusieurs types de segmentation, dans lequel chaque masque de segment est configuré pour masquer des parties des images de puce contenant des structures de puce particulières de sorte que seule une partie de chacune des images de puce soit apparente, dans lequel les un ou plusieurs types de segmentation comportent la détermination d'une puce moyenne basée sur une intensité des images de puce et le seuillage d'une image de la puce moyenne basé sur des valeurs de l'histogramme d'intensité de la puce médiane, dans lequel les valeurs sont une intensité inférieure à 10 %, inférieure à 25 %, inférieure à 50 %, supérieure à 75 % et supérieure à 90 %, dans lequel les un ou plusieurs types de segmentation comportent la soustraction de la puce médiane de chacune des images de puce pour générer un ensemble de puces de différence, et le calcul d'une ou plusieurs composantes principales de l'ensemble de puces de différence ;
l'application, à l'aide d'un processeur, de chaque masque de segment à chaque image de puce pour créer une image de puce masquée, et le calcul d'un ensemble de métriques pour chaque image de puce masquée, dans lequel l'ensemble de métriques comporte un ou plusieurs des éléments suivants : une moyenne d'une image, un écart type d'une image, une moyenne d'une image masquée seuillée, un écart type d'une image masquée seuillée, une moyenne d'une image de gradient masquée dirigée selon x, une moyenne d'une image de gradient masquée dirigée selon y, un écart type d'une image de gradient masquée dirigée selon x et un écart type d'une image de gradient masquée dirigée selon y ; l'identification, à l'aide du processeur, d'une ou de plusieurs combinaisons statistiquement significatives d'une métrique, d'un masque de segmentation et d'une images de plaquette, sur la base des résultats d'inspection des puces, afin de générer un modèle de détection indiquant une conformité ou une non-conformité de processus, dans lequel ledit modèle de détection utilise une régression linéaire pour déterminer une relation de sorte que les résultats d'inspection des puces, indiquant une réponse binaire de conformité ou de non-conformité de processus, soient prédits par une combinaison desdites métriques calculées à partir des images de puce masquées, du masque de segmentation et de l'image de plaquette, et dans lequel les combinaisons statistiquement significatives sont déterminées sur la base du processus ou de la configuration de plaquette particulier ; et
la génération, à l'aide du processeur, d'une image de plaquette résultante pour chaque combinaison d'image de plaquette, de masque de segment et de métrique, ladite image de plaquette résultante comprenant un ensemble d'images de puce résultantes, chaque image de puce résultante représentant visuellement la valeur de métrique calculée pour une puce correspondante sur la plaquette, indiquant ainsi visuellement des variations sur la plaquette qui sont corrélées à une conformité ou à une non-conformité de processus.

2. Procédé selon la revendication 1, dans lequel la pluralité d'images de plaquette comprend une ou plusieurs d'une image en lumière bleue, d'une image en lumière rouge, d'une image en lumière blanche, d'une image en lumière verte, d'une image en champ sombre, d'une image en champ clair et d'une image polarisée.

3. Procédé selon la revendication 1, dans lequel les étapes de réception d'images de plaquette, de réception de résultats d'inspection, de génération de masques de segment et d'application de masques de segment sont répétées pour des images de plaquette supplémentaires comprenant des images de plaquettes supplémentaires non utilisées précédemment, et comprenant également l'étape d'identification, à l'aide du processeur, d'une ou plusieurs combinaisons statistiquement significatives supplémentaires de métrique, de masque de segment et d'image de plaquette, sur la base des résultats d'inspection de puce, afin d'affiner ledit modèle de détection en mettant à jour la relation déterminée par régression linéaire pour intégrer lesdites combinaisons statistiquement significatives supplémentaires, améliorant ainsi la précision du modèle de détection pour indiquer une conformité ou une non-conformité de processus.

4. Procédé de détection de non-conformité d'un processus, comprenant :
la réception d'un modèle généré conformément au procédé revendiqué dans la revendication 1 ;
la réception d'une image de plaquette comprenant un ensemble d'images de puce ;
le masquage de l'image de plaquette à l'aide d'un masque de segment du modèle ;
le calcul d'une métrique de l'image masquée sur la base d'une combinaison correspondante de masque de segment et de métrique du modèle ;
la répétition des étapes de masquage de l'image de plaquette et de calcul d'une métrique sur la base de chaque combinaison de masque de segment et de métrique du modèle ; et
la détermination d'un état de processus sur la base des métriques calculées et du modèle pour détecter un état de conformité ou de non-conformité du processus.

5. Dispositif de génération d'un modèle de détection de non-conformité de processus, comprenant :
un processeur ;
un dispositif de stockage en communication électronique avec le processeur ;
un port de communication en communication électronique avec le processeur ;
dans lequel le processeur est programmé pour :
recevoir, au niveau du port de communication, une pluralité d'images de plaquette, chaque image de plaquette de la pluralité d'images de plaquette comprenant un ensemble d'images de puce ;
recevoir, au niveau du port de communication, un résultat d'inspection de chaque puce correspondant à l'ensemble d'images de puce, dans lequel le résultat d'inspection comprend une indication de réussite ou d'échec pour chaque puce ;
générer un ensemble de masques de segment, les masques de segment étant basés sur les images de puce de chaque ensemble d'images de puce et un ou plusieurs types de segmentation, dans lequel chaque masque de segment est configuré pour masquer des parties des images de puce contenant des structures de puce particulières de sorte que seule une partie de chacune des images de puce soit apparente, dans lequel les un ou plusieurs types de segmentation comportent la détermination d'une puce moyenne basée sur une intensité des images de puce et le seuillage d'une image de la puce moyenne basé sur des valeurs de l'histogramme d'intensité de la puce médiane, dans lequel les valeurs sont une intensité inférieure à 10 %, inférieure à 25 %, inférieure à 50 %, supérieure à 75 % et supérieure à 90 %, dans lequel les un ou plusieurs types de segmentation comportent la soustraction de la puce médiane de chacune des images de puce pour générer un ensemble de puces de différence, et le calcul d'une ou plusieurs composantes principales de l'ensemble de puces de différence ;
appliquer chaque masque de segment à chaque image de puce pour créer une image de puce masquée, et calculer un ensemble de métriques pour chaque image de puce masquée, dans lequel l'ensemble de métriques comporte un ou plusieurs des éléments suivants : une moyenne d'une image, un écart type d'une image, une moyenne d'une image masquée seuillée, un écart type d'une image masquée seuillée, une moyenne d'une image de gradient masquée dirigée selon x, une moyenne d'une image de gradient masquée dirigée selon y, un écart type d'une image de gradient masquée dirigée selon x et un écart type d'une image de gradient masquée dirigée selon y ;
générer une image de plaquette résultante pour chaque combinaison d'image de plaquette, de masque de segment et de métrique, ladite image de plaquette résultante comprenant un ensemble d'images de puce résultantes, chaque image de puce résultante représentant visuellement la valeur de métrique calculée pour une puce correspondante sur la plaquette, indiquant ainsi visuellement des variations sur la plaquette qui sont corrélées à une conformité ou à une non-conformité de processus ; et
identifier des combinaisons statistiquement significatives, sur la base des images de plaquette résultantes et des résultats d'inspection des puces, afin de générer un modèle de détection indiquant une conformité ou une non-conformité de processus, dans lequel ledit modèle de détection utilise une régression linéaire pour déterminer une relation de sorte que les résultats d'inspection des puces, indiquant une réponse binaire de conformité ou de non-conformité de processus, soient prédits par une combinaison desdites métriques calculées à partir des images de puce masquées, du masque de segmentation et de l'image de plaquette, et dans lequel les combinaisons statistiquement significatives sont déterminées sur la base du processus ou de la configuration de plaquette particulier.

6. Dispositif selon la revendication 5, dans lequel le processeur est également configuré pour :
répéter chaque étape du programme pour des plaquettes supplémentaires ; et
affiner le modèle de détection généré en fonction des combinaisons statistiquement significatives pour chaque plaquette en mettant à jour la relation déterminée par régression linéaire afin d'intégrer des combinaisons statistiquement significatives supplémentaires, améliorant ainsi la précision du modèle de détection pour indiquer une conformité ou une non-conformité du processus.

7. Dispositif selon la revendication 5, dans lequel la pluralité d'images de plaquette d'une plaquette comprend une ou plusieurs d'une image en lumière bleue, d'une image en lumière rouge, d'une image en lumière blanche, d'une image en lumière verte, d'une image en champ sombre, d'une image en champ clair et d'une image polarisée.
